# EUROPÄISCHE PATENTSCHRIFT

(11) **EP 2 113 495 B1**
(45) Veröffentlichungstag und Bekanntmachung des Hinweises auf die Patenterteilung: **05.09.2018**
(21) Anmeldenummer: 09159258.4
(22) Anmeldetag: 30.04.2009
(51) Int. Cl.: C04B 35/462, C04B 35/475, H01L 41/187, C04B 35/626

(54) **KERAMISCHER WERKSTOFF, VERFAHREN ZUR HERSTELLUNG DES KERAMISCHEN WERKSTOFFS UND BAUELEMENT MIT DEM KERAMISCHEN WERKSTOFF**
CERAMIC MATERIAL, METHOD FOR PRODUCING THE SAME AND BUILDING COMPONENT CONTAINING THE CERAMIC MATERIAL
MATIÈRE CÉRAMIQUE, PROCÉDÉ DE FABRICATION DE LA MATIÈRE CÉRAMIQUE ET OBJET DE CONSTRUCTION CONTENANT LA MATIÈRE CÉRAMIQUE

(30) Priorität: 30.04.2008 DE 102008021827
(43) Veröffentlichungstag der Anmeldung: 04.11.2009
(73) Patentinhaber: Epcos AG, 81671 München (DE)
(72) Erfinder: Kounga Njiwa, Alain Brice, 8953 Dietikon (CH); Zhang, Shan-Tao, Nanjing 210008 (CN); Rödel, Jürgen, 64342 Seeheim Jugenheim (DE); Jo, Wook, 65824 Schwalbach am Taunus (DE); Granzow, Torsten, 64287 Darmstadt (DE)
(74) Vertreter: Epping - Hermann - Fischer

(56) Entgegenhaltungen:
- JP-A- 2002 220 280
- US-A- 6 004 474
- YUE-MING LI ET AL: "Dielectric and Piezoelectric Properties of Na0.5Bi0.5TiO3-K0.5Bi0.5Ti O3-NaNbO3Lead-Free Ceramics" JOURNAL OF ELECTROCERAMICS, KLUWER ACADEMIC PUBLISHERS, BO, Bd. 14, Nr. 1, 1. Januar 2005 (2005-01-01) , Seiten 53-58, XP019208265 ISSN: 1573-8663
- YING YUAN ET AL: "Dielectric and piezoelectric properties of (0.97-x) Bi1/2Na1/2TiO3-xBi1/2K1/2TiO3-0.03NaNbO3 ceramics" JOURNAL OF MATERIALS SCIENCE, KLUWER ACADEMIC PUBLISHERS, BO, Bd. 41, Nr. 11, 12. April 2006 (2006-04-12), Seiten 3561-3567, XP019398986 ISSN: 1573-4803
- GUIFEN FAN ET AL: "Phase transition behaviour and electromechanical properties of (Na1/2Bi1/2)TiO3â KNbO3 lead-free piezoelectric ceramics" JOURNAL OF PHYSICS D. APPLIED PHYSICS, IOP PUBLISHING, BRISTOL, GB, Bd. 41, Nr. 3, 7. Februar 2008 (2008-02-07), Seite 35403, XP020127018 ISSN: 0022-3727
- JOURNAL OF THE AMERICAN CERAMIC SOCIETY AUGUST 2007 BLACKWELL PUBLISHING INC.; COMMERCE PLACE US, Bd. 90, Nr. 8, August 2007 (2007-08), Seiten 2424-2428, XP002569013
- ZUO RUZHONG ET AL: "Phase structures and electrical properties of new lead-free (Na0.5K0.5)NbO3-(Bi0.5Na0.5)TiO3 ceramics", APPLIED PHYSICS LETTERS, AMERICAN INSTITUTE OF PHYSICS, US, vol. 90, no. 9, 1 March 2007 (2007-03-01), pages 92904-092904, XP012096267, ISSN: 0003-6951, DOI: 10.1063/1.2710768

## Beschreibung

Die Erfindung betrifft einen keramischen Werkstoff und ein Verfahren zur Herstellung des keramischen Werkstoffs. Weiterhin betrifft die Erfindung ein Bauelement, das den keramischen Werkstoff umfasst, sowie die Verwendung des Bauelements.

Werkstoffe, die bei einem bestimmten angelegten elektrischen Feld eine Veränderung ihrer räumlichen Ausdehnung aufweisen, also piezoelektrische Eigenschaften aufweisen, werden beispielsweise in Aktoren eingesetzt. Für diese Anwendung sind hohe Dehnungen des Werkstoffs als Antwort auf das angelegte elektrische Feld erwünscht. Die erreichbare Dehnung ist bei den Werkstoffen durch die elektrische Durchschlagsfestigkeit des Werkstoffs begrenzt. Herkömmliche piezoelektrische Werkstoffe enthalten zudem einen hohen Anteil von Blei, was für Mensch und Umwelt schädlich ist.

Das Dokument Yue-Ming Li et al.: "Dielectric and Piezoelectric Properties of Na0.5Bi0.5TiO3-K0.5Bi0.5TiO3-NaNbO3 Lead-Free Ceramics" JOURNAL OF ELECTROCERAMICS, KLUWER ACADEMIC PUBLISHERS 2005, vol. 14, Nr. 1, Seiten 53-58, zeigt die Herstellung eines keramischen Werkstoffs mit der Formel (1-x)[0,88(Bi_{0,5}Na_{0,5}TiO₃)-0,12(Bi_{0,5}K_{0,5}TiO₃)]-xNaNbO₃. Man nimmt die einzelnen Oxide oder Karbonate der Elemente K, Bi, Na, Ti und Nb. Diese Ausgangsmaterialien werden in Alkohol gemahlen, getrocknet und danach bei 900°C (2 Stunden) kalziniert. Danach wird das erhaltene Pulver in Scheiben gepresst und bei 1150-1200°C gesintert. Am Ende werden noch zwei Silberelektroden aufgebracht.

Das Dokument Zuo Ruzhong et al.: "Phase structures and electrical properties of new lead-free (Na0.5K0.5)NbO3-(Bi0.5Na0.5)TiO3 ceramics", APPLIED PHYSICS LETTERS, AMERICAN INSTITUTE OF PHYSICS, US, Bd. 90, Nr. 9, 1. März 2007, Seiten 92904-092904, zeigt einen keramischen piezoelektrischen Werkstoff mit der Zusammensetzung (1-x)(Na_{0,5}K_{0,5}NbO₃) x(Bi_{0,5}Na_{0,5}TiO₃) und den Werten 0,005, 0,01, 0,02 0,03, 0,05, 0,09, 0,15, 0,2, 0,8, und 1,0 für x. Die pulverförmigen Oxid- und Karbonat-Ausgangsverbindungen werden vermischt, gemahlen in Ethanol, getrocknet, bei 900°C kalziniert, in Scheiben gepresst und bei 1020-1150°C gesintert. Silberelektroden werden nach der Sinterung angebracht. Das resultierende Bauelement kann als Piezoaktor verwendet werden.

Das Dokument JP2002220280A zeigt die Herstellung eines keramischen Werkstoffs mit der Formel: (1-x-y)(Bi_{0,5}Na_{0,5}TiO₃)-x(Bi_{0,5}K_{0,5}TiO₃)-yNaNbO₃. Man nimmt die einzelnen Oxide oder Karbonate der Elemente K, Bi, Na, Ti und Nb. Diese Ausgangsmaterialien werden in Alkohol gemahlen, getrocknet und danach bei 900°C kalziniert. Danach wird das erhaltene Pulver in Scheiben gepresst und bei 1100-1300°C gesintert. Am Ende werden noch Silberelektroden aufgebracht. Das resultierende Bauelement wird als Aktor verwendet.

Aufgabe der Erfindung ist es, einen neuen keramischen Werkstoff mit piezoelektrischen Eigenschaften bereitzustellen, der eine hohe Dehnung bei einem angelegten elektrischen Feld und dabei eine hohe elektrische Durchschlagsfestigkeit aufweist. Diese Aufgabe wird durch einen Werkstoff gemäß Anspruch 1 gelöst. Gegenstand weiterer Ansprüche sind Ausführungsformen des keramischen Werkstoffs, Herstellungsverfahren für den keramischen Werkstoff und ein Bauelement mit dem keramischen Werkstoff.

Die vorliegende Erfindung betrifft einen binären keramischen Werkstoff, mit einer Bismutnatriumtitanat Komponente und einer Kaliumnatriumniobat Komponente, mit der Zusammensetzung (1-x)(Bi_{0.5}Na_{0.5}TiO₃)x(K_{0.5}Na_{0.5}NbO₃) mit 0,11 ≤ x ≤ 0,12.

Beschrieben wird außerdem ein binärer keramischer Werkstoff, der die Formel (1 - x)(Bi_{0,5}Na_{0,5}TiO₃)x(K_{0,5}Na_{0,5}NbO₃) mit 0 < x ≤ 0,15 umfasst. Binär bedeutet, dass der keramische Werkstoff aus zwei Komponenten, Bismutnatriumtitanat Bi_{0,5}Na_{0,5}TiO₃ und Kaliumnatriumniobat K_{0,5}Na_{0,5}NbO₃, zusammengesetzt ist, wobei die Anteile der beiden Komponenten je nach eingesetztem Wert x variabel sind.

Der beschriebene Werkstoff kann die oben genannte Zusammensetzung aufweisen mit 0,08 ≤ x ≤ 0,12. Werkstoffe, die diesen Bereich für x umfassen, weisen eine hohe Dehnung und eine gute elektrische und mechanische Stabilität auf.

In einer Ausführungsform der Erfindung kann der Werkstoff weiterhin frei von Blei sein. Somit wird der Einsatz des toxischen Bleis, beispielsweise in Aktoren, vermieden und der Umgang mit dem Werkstoff erleichtert. Damit können beispielsweise elektronische Bauelemente mit diesem Werkstoff hergestellt werden, die für Mensch und Umwelt unbedenklich sind.

Beschrieben wird zudem ein Werkstoff der einen Bereich für x aufweist, der bei 0,06 ≤ x ≤ 0,075 liegt, wobei der Werkstoff eine morphotrope Phasengrenze aufweist (MPB, engl. morphotropic phase boundary). Das Vorliegen einer morphotropen Phasengrenze bedeutet die Koexistenz einer rhomboedrischen Kristallstruktur und einer tetragonalen Kristallstruktur des keramischen Werkstoffs, die beispielsweise durch röntgendiffraktometrische Untersuchungen identifiziert werden kann. Die einzelnen Komponenten des Werkstoffs tragen dabei zu dieser Phasengrenze bei. Bismutnatriumtitanat weist eine rhomboedrische Kristallstruktur auf, Kaliumnatriumniobat eine orthorhombische Kristallstruktur. Die Materialzusammensetzung, in der beide Kristallstrukturen, die rhomboedrische und die tetragonale Kristallstruktur, koexistieren, wird als MPB-Zusammensetzung bezeichnet. In der Umgebung dieser Phasengrenze können piezoelektrische Eigenschaften des Werkstoffs, beispielsweise der Kopplungsfaktor oder die Dielektrizitätskonstante des Werkstoffs, höher sein, als in Bereichen außerhalb der morphotropen Phasengrenze. Für x < 0,06 ist nur eine rhomboedrische Kristallstruktur vorhanden, für x > 0,075 ist nur eine tetragonale Kristallstruktur vorhanden.

In einer Ausführungsform der vorliegenden Erfindung nimmt der Parameter x des Werkstoffs den Wert x = 0,11 an. Misst man die Dehnung des Werkstoffs (1-x)(Bi_{0,5}Na_{0,5}TiO₃)x(K_{0,5}Na_{0,5}NbO₃)mit x = 0,11, so erhält man eine Dehnung von über 0,4% bei einem angelegten Feld von 8 kV/mm.

Der Parameter x des erfindungsgemäßen Werkstoffs kann weiterhin den Wert x = 0,12 annehmen. Bei einem angelegten Feld von 8 kV/mm weist ein Werkstoff mit x = 0,12 eine Dehnung von 0,22% auf. Eine Dehnung von über 0,4% kann erreicht werden, wenn ein elektrisches Feld, beispielsweise 9 kV/mm, gewählt wird. Werkstoffe dieser Art weisen eine gute elektrische Durchschlagsfestigkeit auf. Im Vergleich zu ternären Werkstoffen, die aus drei Komponenten zusammengesetzt sind, weist der binäre Werkstoff weiterhin weniger Kationen in einer Einheitszelle der Kristallstruktur auf, was eine gute Homogenität und einfache Handhabung des Werkstoffs ermöglichen kann.

Je größer der Parameter x des binären keramischen Werkstoffs gewählt wird, desto mehr wird die negative Dehnung in dem Werkstoff reduziert. Negative Dehnung bedeutet die Differenz zwischen der Dehnung des Werkstoffs ohne angelegtes elektrisches Feld (Null-Feld), nachdem bereits ein Feld zur Polarisierung des Werkstoffs angelegt wurde, und der niedrigsten messbaren Dehnung des Werkstoffs.

Weiterhin wird beschrieben, dass es möglich ist, durch die Mischung von Kaliumnatriumniobat und Bismutnatriumtitanat, die zusammen eine feste Lösung ergeben, in dem Werkstoff (1-x)(Bi_{0,5}Na_{0,5}TiO₃)x(K_{0,5}Na_{0,5}NbO₃) mit 0,09 ≤ x ≤ 0,012 bei Raumtemperatur und niedrigen Frequenzen von bis zu 5 Hz des elektrischen Feldes einen Phasenübergang von der antiferroelektrischen Phase in die ferroelektrische Phase elektrisch zu induzieren. Dieser Übergang und eine daran anschließende Domänenumorientierung in der ferroelektrischen Phase bedingen hohe Dehnungen des Werkstoffs.

Je nach Zusammensetzung des Werkstoffs werden weiterhin Restspannungen im Werkstoff erzeugt, die einen Domänenrelaxationsprozess hervorrufen, wenn das angelegte elektrische Feld abgeschaltet wird. Ebenso geht beim Abschalten des elektrischen Feldes die durch das Feld induzierte ferroelektrische Phase in die antiferroelektrische Phase über. Dadurch wird eine remanente Polarisation, die bleibende Polarisation bei abgeschaltetem Feld, und eine geringe negative Dehnung bedingt. Somit kann bei erneutem Anlegen eines elektrischen Feldes eine mit der sonst einmaligen hohen Polungsdehnung vergleichbare Dehnung erreicht werden. In herkömmlichen piezoelektrischen Werkstoffen ist die Dehnung beim ersten Polungsvorgang größer als die Dehnung bei den darauf folgenden unipolaren Polungsvorgängen. Kleine negative Dehnungen sind somit erwünscht, um bei jedem weiteren unipolaren Belastungszyklus, also Polungsvorgang, Dehnungen, die ähnlich groß wie die Polungsdehnung sind, zu erreichen.
Es wird weiterhin ein Verfahren zur Herstellung eines Werkstoffs mit den oben genannten Eigenschaften bereitgestellt. Das Verfahren umfasst die Verfahrensschritte A) Vermischen von pulverförmigen, sauerstoffhaltigen Verbindungen von Bi, Na, K, Ti und Nb im stöchiometrischen Verhältnis zur Herstellung einer Ausgangsmischung, B) Mahlen und Kalizinieren der Ausgangsmischung zur Herstellung einer pulverförmigen festen Lösung, und C) Pressen und Sintern der pulverförmigen festen Lösung. Damit kann der Werkstoff beispielsweise mit einem Mischoxidverfahren hergestellt werden, wobei das stöchiometrische Verhältnis so gewählt wird, dass ein Werkstoff der Zusammensetzung (1 - x)(Bi_{0,5}Na_{0,5}TiO₃)x(K_{0,5}Na_{0,5}NbO₃) mit 0,11 ≤ x ≤ 0,12 hergestellt wird. Beschrieben wird zudem dasselbe Verfahren, wobei das stöchiometrische Verhältnis so gewählt wird, dass ein Werkstoff der Zusammensetzung (1 - x) (Bi_{0,5}Na_{0,5}TiO₃)x(K_{0,5}Na_{0,5}NbO₃) mit 0 < x ≤ 0,15 hergestellt wird.
In dem Verfahren können im Verfahrensschritt A) Ausgangsmaterialien aus einer Gruppe ausgewählt werden, die Oxide und Carbonate von Bi, Na, K, Ti und Nb umfasst. Es können beispielsweise Bi₂O₃, Na₂Co₃, K₂Co₃, TiO₂ und Nb₂O₅ ausgewählt werden. Diese Verbindungen werden gemäß dem gewünschten stöchiometrischen Verhältnis abgewogen und gemischt.

Weiterhin kann im Verfahrensschritt B) die Ausgangsmischung in einem Lösungsmittel gemahlen, getrocknet und bei einer Temperatur, die einen Bereich von 800°C bis 950°C umfasst, kaliziniert werden. Als Lösungsmittel kann dabei beispielsweise wasserfreies Ethanol gewählt werden, und das Kalzinieren beispielsweise bei einer Temperatur von 900°C bei einer Haltezeit von beispielsweise drei Stunden durchgeführt werden.

Weiterhin kann im Verfahrensschritt C) die pulverförmige feste Lösung gemahlen werden, beispielsweise während einer Zeit von 24 Stunden. Die gemahlene pulverförmige feste Lösung kann in Scheiben gepresst werden, die Grünkörper sind, und bei einer Temperatur gesintert werden, die einen Bereich von 1050°C bis 1150°C umfasst. Die gepressten Scheiben können beispielsweise einen Durchmesser von 10 mm umfassen und bei 70 MPa gepresst werden. Die Sintertemperatur kann beispielsweise 1050° C betragen und in einem aluminiumbeschichteten Behälter durchgeführt werden. Um ein Verflüchtigen der leicht flüchtigen Elemente Bismut, Natrium und Kalium zu vermeiden, können die gepressten Scheiben während der Sinterung in den entsprechenden Pulvern eingebettet werden. Die Dichte des gesinterten Werkstoffs kann zwischen 95% und 98% der theoretischen Dichte betragen.

Es wird weiterhin ein Bauelement bereitgestellt, das zumindest einen keramischen Grundkörper und zumindest zwei auf dem Grundkörper angeordnete Elektroden aufweist, wobei die Keramikschicht einen Werkstoff mit den oben genannten Eigenschaften aufweist. Das Bauelement kann weiterhin einen Grundkörper umfassen, der eine Vielzahl von gestapelten Keramikschichten mit dazwischen angeordneten Elektroden umfasst, wobei die Elektroden aus den gestapelten Keramikschichten herausführen und über Außenelektroden kontaktiert sind. Die Elektroden können beispielsweise wechselseitig kontaktiert werden. Dadurch können Bauelemente bereitgestellt werden, die bei Anlegen einer Spannung eine Dehnung ihres Volumens aufweisen.

Ein solches Bauelement kann beispielsweise als Piezoaktor oder Vielschichtaktor verwendet werden. Ein Piezoaktor kann beispielsweise für Einspritzsysteme eingesetzt werden. Es sind aber auch weitere Verwendungsmöglichkeiten mit einem der oben genannten Werkstoffe denkbar.

Anhand der Figuren und Ausführungsbeispiele soll die Erfindung näher erläutert werden:
Figur 1 zeigt SEM-Aufnahmen des Gefüges für beispielhafte Werkstoffe,
Figur 2 zeigt die Polarisationshysterese für beispielhafte Werkstoffe,
Figur 3 zeigt die maximale Polarisation, die remanente Polarisation und das Koerzitivfeld für beispielhafte Werkstoffe,
Figur 4 zeigt die bipolare Dehnungshysterese von beispielhaften Werkstoffen,
Figur 5 zeigt die unipolare Dehnungshysterese von beispielhaften Werkstoffen,
Figur 6 zeigt die Abhängigkeit der maximalen Dehnung von der Zusammensetzung des Werkstoffs,
Figur 7 zeigt den piezoelektrischen Koeffizienten und den Kopplungsfaktor in Abhängigkeit der Zusammensetzung des Werkstoffs,
Figur 8 zeigt die schematische Seitenansicht eines Bauelements mit dem Werkstoff.

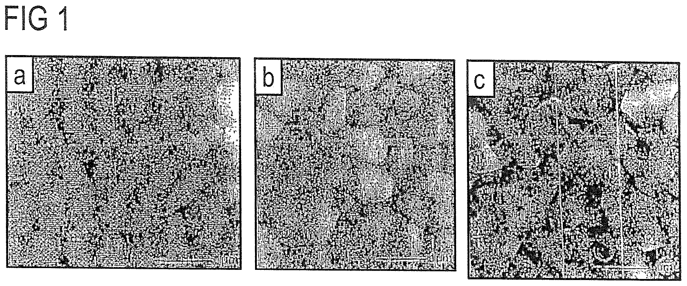

Figur 1 zeigt SEM-Aufnahmen (Rasterelektronenmikroskopie) des Gefüges des Werkstoffs. In Figur 1a ist das Gefüge eines herkömmlichen Werkstoffs aus reinem Bismunatriumtitanat (Referenz x = 0) gezeigt, in Figur 1b ein Referenz-Werkstoff der Formel (1 - x)(Bi_{0,5}Na_{0,5}TiO₃)x(K_{0,5}Na_{0,5}NbO₃)mit x = 0,06 und in Figur 1c ein erfindungsgemäßer Werkstoff der Formel (1 - x) (Bi_{0,5}Na_{0,5}TiO₃)x(K_{0,5}Na_{0,5}NbO₃)mit x = 0,12. Die verschiedenen Gefüge zeigen, dass keine sekundären Phasen vorhanden sind und dass die Korngröße in dem Werkstoff mit zunehmendem x kleiner wird. So ist die mittlere Korngröße für x = 0 1,2 µm und für x = 0,12 0,7 pm.

Für die SEM-Aufnahmen werden die jeweiligen Proben poliert, und für 45 Minuten bei 900°C (für x = 0 bei 830°C) thermisch geätzt.

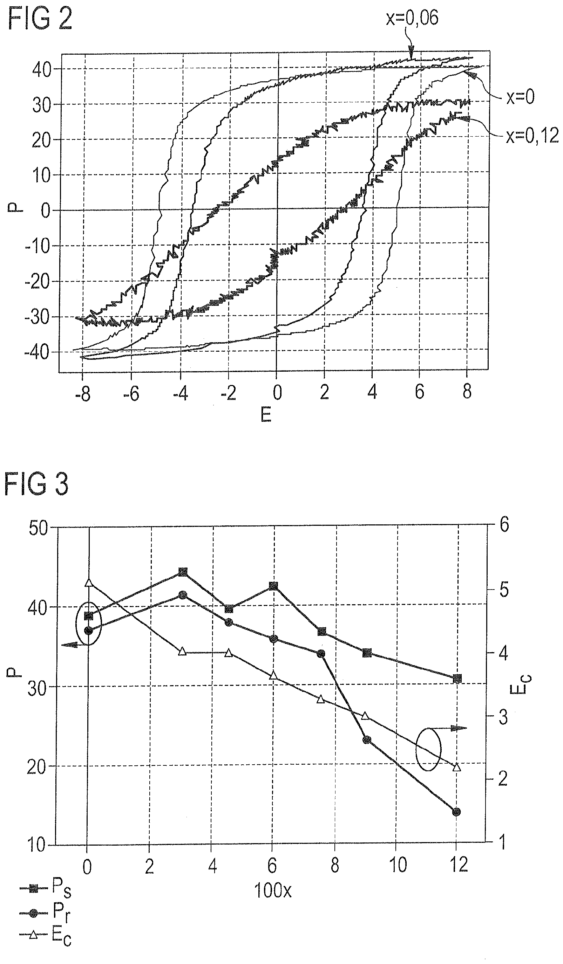

Die elektrischen Messungen an dem Werkstoff, die in den folgenden Figuren 2 bis 7 gezeigt werden, wurden an gesinterten Scheiben-Proben des jeweiligen Werkstoffs durchgeführt. Auf den breiten Scheibenflächen wird vor den Messungen eine dünne Silberschichtaufgebracht und für 30 Minuten bei 500°C getrocknet. Dadurch werden Silberschichten erhalten, die als Elektroden für die elektrischen Messungen dienen.

Figur 2 zeigt die Polarisationshysterese für Werkstoffe mit x = 0 (Referenz), x = 0,06 (Referenz) und x = 0,12 (erfindungsgemäßer Werkstoff). Dabei ist die angelegte Feldstärke E in kV/mm gegen die Polarisation P in µC/cm² aufgetragen. Für die Messung wird ein elektrisches Feld mit dreieckiger Wellenform und mit einer Frequenz von 50 mHz gewählt. Es ist zu sehen, dass mit größer werdendem x die Koerzitivfeldstärke E_{c}, die Feldstärke bei P = 0, abnimmt. Bei einem Feld von E = 8 kV/mm tritt eine Sättigung der Polarisation ein.

Die Werte für die Koerzitivfeldstärke E_{c}, die maximale Polarisation Pₛ und die remanente Polarisation Pᵣ (bei E = 0 kV/mm) sind für weitere beispielhafte Werkstoffe in Figur 3 angegeben. Hier ist die Zusammensetzung des Werkstoffs ausgedrückt durch den Wert von x (in %) gegen die Polarisation P in µC/cm² aufgetragen. Alle drei Werte Pᵣ, Pₘ und E_{c} ändern sich bis x = 0,06 wenig, und zeigen für x > 0.06 einen starken Abfall. E_{c} fällt beispielsweise von 5,1 kV/mm auf 2,2 kV/mm.

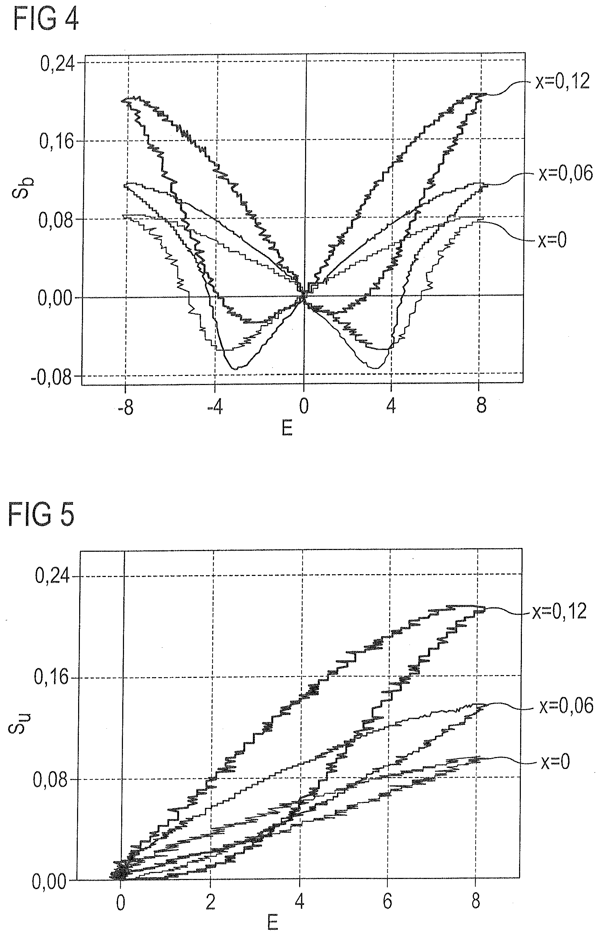

In den Figuren 4 bis 6 sind Messungen der Dehnung in Abhängigkeit des angelegten Feldes gezeigt. Diese Messungen wurden in einem Ölbad bei einer Frequenz von 50 mHz und mit einer dreieckigen Wellenform des Feldes durchgeführt.

In Figur 4 ist die bipolare Dehnung S_{b} in % in Abhängigkeit des angelegten elektrischen Feldes E in kV/mm für Werkstoffe mit x = 0 (Referenz), x = 0,06 (Referenz) und x = 0,12 (erfindungsgemäßer Werkstoff) gezeigt. Bei einer bipolaren Dehnung wird das angelegte Feld E von 0 kV/mm auf 8 kV/mm erhöht, dann auf -8 kV/mm umgekehrt und schließlich wieder auf 0 kV/mm erhöht. Eine bipolare Variation des Feldes führt zu einer Dehnungskurve, die eine Schmetterlingsform aufweist.

In Figur 5 ist analog zu Figur 4 die unipolare Dehnung Sᵤ in % gezeigt. Hier wird das angelegte Feld E von 0 kV/mm auf 8 kV/mm erhöht und wieder auf 0 kV/mm erniedrigt. Eine unipolare Variation des Feldes führt zu einer Dehnungshysterese der untersuchten Proben.

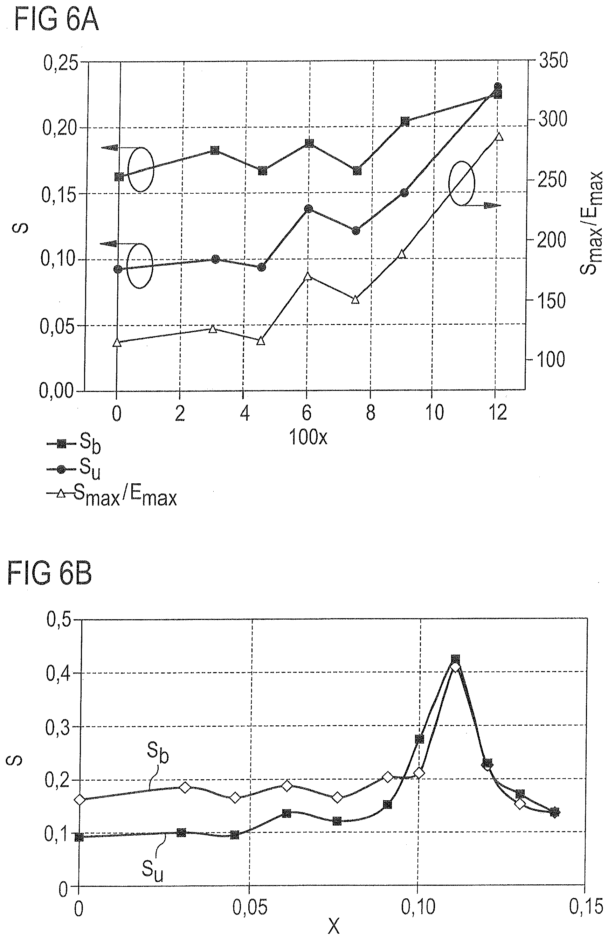

In Figur 6a sind die charakteristischen Werte für Werkstoffe der Messungen, die für drei beispielhafte Werkstoffe in den Figuren 4 und 5 gezeigt sind, zusammengefasst. Die charakteristischen Werte sind die maximale bipolare Dehnung S_{b} und die maximale unipolare Dehnung Sᵤ, und als normierte Größe das Verhältnis der maximalen unipolaren Dehnung Sₘₐₓ zu dem maximal angelegten Feld Eₘₐₓ Sₘₐₓ/Eₘₐₓ in pm/V in Abhängigkeit der Zusammensetzung des Werkstoffs in Form von x in %. Figur 6b zeigt ebenfalls die Dehnungen Sᵤ und S_{b} in Abhängigkeit von x für weitere ausgewählte x-Werte. Es sind maximale Dehnungen für x = 0,11 zu sehen.

In Figur 6 ist zu sehen, dass die Dehnung Sᵤ und S_{b} mit zunehmendem x, also mit zunehmendem Anteil von Kaliumnatriumniobat in dem Werkstoff, ansteigt, insbesondere in dem Bereich x > 0,075 also außerhalb des morphotropen Phasengrenzbereichs. Gleichzeitig nimmt die negative Dehnung, die Differenz der Dehnung bei E = 0 kV/mm und der niedrigsten Dehnung ab (Figur 4).

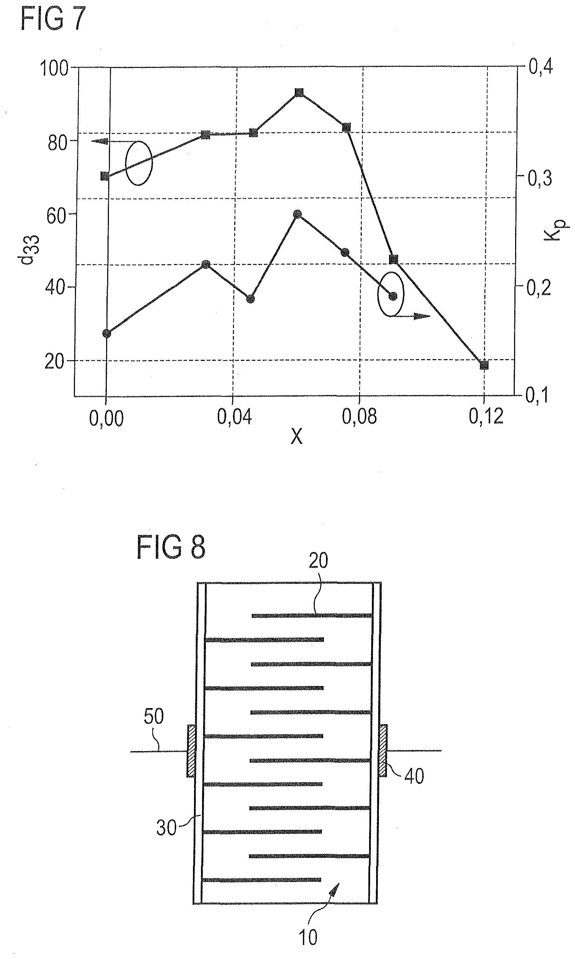

In Figur 7 ist der piezolelektrische Koeffizient d₃₃ in pC/N (oder pm/V) und der Kopplungsfaktor kₚ in Abhängigkeit von x gezeigt. d₃₃ wurde bei E = 0 kV/mm mit einem Berlincourtmeter ermittelt, mit Proben, die bei einem Feld von 7 kV/mm für 5 Minuten bei Raumtemperatur gepolt wurden. Der elektromechanische Kopplungsfaktor kₚ wurde mit einer Resonanz-Antiresonanz-Methode in einem Impedanz-Analysator ermittelt. d₃₃ zeigt ein Maximum von 94 pm/V bei x = 0.06 und wird < 20 pm/V für x = 0,12.
Bei einer temperaturabhängigen Messung (bei Temperaturen von 50°C bis 400°C) der dielektrischen Permittivität εᵣ bei Frequenzen von 100 Hz bis 1 MHz zeigt ein Werkstoff mit x = 0 (Referenz) ein Maximum von εᵣ bei T = 296°C. Mit größer werdendem x wird diese Temperatur zu kleineren Werten (208°C bis 273°C) verschoben. Die Übergangstemperatur T_{d}, bei der der Übergang von der ferroelektrischen in die antiferroelektrische Phase stattfindet, die mittels dielektrischen Messungen ermittelt werden kann, beträgt bei x = 0 185°C, und bei x > 0,075 weniger als 150°C, beispielsweise 100°C bis 146°C je nach Zusammensetzung.

Figur 8 zeigt die schematische Seitenansicht eines Bauelements, das den Werkstoff in einer der oben beschriebenen Ausführungen enthält. Das Bauelement weist einen keramischen Grundkörper 10 auf, der aus mehreren Keramikschichten aufgebaut ist, die zu einem monolithischen Grundkörper gesintert sind. Die Keramikschichten weisen den keramischen binären Werkstoff auf. Zwischen den Keramikschichten sind Elektroden 20 angeordnet. Weiterhin sind an den Seiten des Grundkörpers Außenelektroden 30 angeordnet, die die Elektroden 20 in dem Grundkörper wechselseitig kontaktieren. Auf den Außenelektroden sind Anschlusselemente 40 vorhanden, die über Leiter 50 kontaktiert sind.

Dieses Bauelement kann beispielsweise als Piezoaktor in einem Einspritzsystem verwendet werden. Wird über die Leiter 50 ein Feld angelegt, weist der Grundkörper 10 eine Dehnung auf. Bei Abschalten des Feldes geht auch die Dehnung des Grundkörpers zurück.

### Bezugszeichenliste

- 10: keramischer Grundkörper
- 20: Elektrode
- 30: Außenelektrode
- 40: Anschlußelement
- 50: Leiter

## Patentansprüche

1. Binärer keramischer Werkstoff, mit einer Bismutnatriumtitanat Komponente und einer Kaliumnatriumniobat Komponente, mit der Zusammensetzung (1-x)(Bi_{0.5}Na_{0.5}TiO₃)x(K_{0.5}Na_{0.5}NbO₃) mit 0,11 ≤ x ≤ 0,12.

2. Werkstoff nach dem vorhergehenden Anspruch, der frei von Blei ist.

3. Verfahren zur Herstellung eines Werkstoffs gemäß den Ansprüchen 1 oder 2 mit den Verfahrensschritten
A) Vermischen von pulverförmigen sauerstoffhaltigen Verbindungen von Bi, Na, K, Ti und Nb im stöchiometrischen Verhältnis zur Herstellung einer Ausgangsmischung,
B) Mahlen und Kalzinieren der Ausgangsmischung zur Herstellung einer pulverförmigen festen Lösung,
C) Pressen und Sintern der pulverförmigen festen Lösung.

4. Verfahren nach dem vorhergehenden Anspruch, wobei im Verfahrensschritt A) Ausgangsmaterialien aus einer Gruppe ausgewählt werden, die Oxide und Carbonate von Bi, Na, K, Ti und Nb umfasst.

5. Verfahren nach einem der Ansprüche 3 oder 4, wobei im Verfahrensschritt B) die Ausgangsmischung in einem Lösungsmittel gemahlen, getrocknet und bei einem Temperaturbereich von 800°C bis 950°C kalziniert wird.

6. Verfahren nach einem der Ansprüche 3 bis 5, wobei im Verfahrensschritt C) die gemahlene pulverförmige feste Lösung in Scheiben gepresst wird und bei einer Temperatur gesintert wird, die einen Bereich von 1050°C bis 1150°C umfasst.

7. Bauelement, das zumindest einen keramischen Grundkörper und zumindest zwei auf dem Grundkörper (10) angeordnete Elektroden (20) aufweist, wobei der Grundkörper einen Werkstoff gemäß den Ansprüchen 1 oder 2 aufweist.

8. Bauelement nach dem vorhergehenden Anspruch, wobei der Grundkörper eine Vielzahl von gestapelten Keramikschichten mit dazwischen angeordneten Elektroden (20) umfasst, wobei die Elektroden (20) aus den gestapelten Keramikschichten herausführen und über Außenelektroden (30) kontaktiert sind.

9. Verwendung des Bauelements nach einem der Ansprüche 7 oder 8 als Piezoaktor.

## Claims

1. Binary ceramic material, having a bismuth sodium titanate component and a potassium sodium niobate component, having the composition (1-x)(Bi_{0.5}Na_{0.5}TiO₃)x(K_{0.5}Na_{0.5}NbO₃), where 0.11 ≤ x ≤ 0.12.

2. Material according to the preceding claim, said material being lead-free.

3. Method for the production of a material according to any of Claims 1 and 2, comprising the following method steps:
A) pulverulent oxygen-containing compounds of Bi, Na, K, Ti and Nb are mixed in a stoichiometric ratio to produce a starting mixture,
B) the starting mixture is ground and calcined to produce a pulverulent solid solution,
C) the pulverulent solid solution is pressed and sintered.

4. Method according to the preceding claim, wherein, in method step A), starting materials are selected from a group comprising oxides and carbonates of Bi, Na, K, Ti and Nb.

5. Method according to any of Claims 3 and 4, wherein, in method step B), the starting mixture is ground in a solvent, dried and calcined at a temperature in the range of 800°C to 950°C.

6. Method according to any of Claims 3 to 5, wherein, in method step C), the ground pulverulent solid solution is pressed to form disks and sintered at a temperature in the range of 1050°C to 1150°C.

7. Component having at least one ceramic basic body and at least two electrodes (20) arranged on the basic body (10), wherein the basic body has a material according to any of Claims 1 and 2.

8. Component according to the preceding claim, wherein the basic body comprises a multiplicity of stacked ceramic layers with electrodes (20) arranged therebetween, wherein the electrodes (20) lead out from the stacked ceramic layers and are contacted via external electrodes (30).

9. Use of the component according to any of Claims 7 and 8 as a piezo actuator.

## Revendications

1. Matériau céramique binaire présentant un composant de titanate de bismuth et de sodium et un composant de niobate de potassium et de sodium, de composition (1-x)(Bi_{0.5}Na_{0.5}TiO₃)x(K_{0.5}Na_{0.5}NbO₃) avec 0,11 ≤ x ≤ 0,12.

2. Matériau selon la revendication précédente, exempt de plomb.

3. Procédé de fabrication d'un matériau selon les revendications 1 ou 2, présentant les étapes qui consistent à :
A) mélanger des composés pulvérulents de Bi, Na, K, Ti et Nb et d'oxygène dans un rapport stoechiométrique en vue de préparer un mélange de départ,
B) broyer et calciner le mélange de départ pour former une solution solide pulvérulente et
C) comprimer et fritter la solution solide pulvérulente.

4. Procédé selon la revendication précédente dans lequel à l'étape A) du procédé, on sélectionne le matériau de départ dans un ensemble qui comporte des oxydes et des carbonates de Bi, Na, K, Ti et Nb.

5. Procédé selon l'une des revendications 3 ou 4, dans lequel à l'étape B) du procédé, le mélange de départ est broyé dans un solvant, et calciné dans une plage de température comprise entre 800°C et 950°C.

6. Procédé selon l'une des revendications 3 à 5, dans lequel à l'étape C) du procédé, la solution solide pulvérulente broyée est comprimée en disques et frittée à une température comprise dans une plage de 1 050°C à 1 150°C.

7. Composant qui présente au moins un corps de base en céramique et au moins deux électrodes (20) disposées sur le corps de base (10), le corps de base présentant un matériau selon l'une des revendications 1 ou 2.

8. Composant selon la revendication précédente, dans lequel le corps de base comporte plusieurs couches céramiques empilées entre lesquelles sont disposées des électrodes (20), les électrodes (20) débordant hors des couches en céramique empilées et étant mises en contact par des électrodes extérieures (30).

9. Utilisation du composant selon l'une des revendications 7 et 8 comme piézo-actionneur.
